# EUROPEAN PATENT SPECIFICATION

(11) **EP 4 095 902 B1**
(45) Date of publication and mention of the grant of the patent: **10.01.2024**
(21) Application number: 22175780.0
(22) Date of filing: 27.05.2022
(51) Int. Cl.: H01L 23/498, H01L 23/538, H01L 23/64

(54) **ELECTRONIC COMPONENT PACKAGE BODY, ELECTRONIC COMPONENT PACKAGE ASSEMBLY, AND ELECTRONIC DEVICE**
GEHÄUSE FÜR ELEKTRONISCHE KOMPONENTEN, BAUGRUPPE ELEKTRONISCHER KOMPONENTEN UND ELEKTRONISCHE VORRICHTUNG
CORPS DE BOÎTIER DE COMPOSANT ÉLECTRONIQUE, ENSEMBLE BOÎTIER DE COMPOSANT ÉLECTRONIQUE ET DISPOSITIF ÉLECTRONIQUE

(30) Priority: 29.05.2021 CN 202110595978
(43) Date of publication of application: 30.11.2022
(73) Proprietor: Huawei Technologies Co., Ltd., Shenzhen, Guangdong 518129 (CN)
(72) Inventor: XIANG, Zhiqiang, Shenzhen, 518129 (CN)
(74) Representative: Körber, Martin Hans

(56) References cited:
- EP-A1- 1 876 642
- EP-A1- 1 895 590
- JP-A- H11 145 599
- US-A1- 2005 168 960
- US-A1- 2014 312 458
- US-A1- 2021 013 131
- US-A1- 2021 066 197

## Description

### TECHNICAL FIELD

This application relates to the field of packaging technologies, and in particular, to an electronic component package body, an electronic component package assembly, and an electronic device.

### BACKGROUND

As a development trend of electronic products is towards multi-functionality and portability, embedded chip packaging has become a hot research topic in the field of electronic component packaging technologies. In an existing embedded chip substrate, a land grid array (land grid array, LGA) is generally used to fasten a package body and a circuit board. However, because the land grid array is a surface-mount packaging technology, a package assembly and the circuit board are soldered through surface contact. Soldering reliability is poor, and a soldering joint easily breaks, affecting reliability of the package assembly
US 2005/0168960 A1 discloses a module for an electronic device. The module includes an insulating sheet substrate, which has an upper surface, a lower surface opposed to the upper surface and a side surface, which connects the surfaces. Further, at least one wiring is provided, which extends from the upper surface to the lower surface through the side surface, and an electronic component is provided, which is disposed within the sheet substrate. US 2014/0312458 A1 discloses a method for forming a redistribution layer on a substrate.

### SUMMARY

This application provides an electronic component package body, an electronic component package assembly, and an electronic device. The present invention is defined in the independent claims. Advantageous features are defined in the dependent claims. In the following, embodiments, which are not covered by the claims, are to be considered as examples necessary for understanding the invention.

Pins of the electronic component package body provided in this application have soldering areas of different dimensions, so that reliability of soldering the electronic component package body and a circuit board is improved.

The claimed invention provides an electronic component package body The electronic component package body includes a substrate, an electronic component, and first pins. The substrate includes a bottom surface, a top surface, and a first side surface. The bottom surface and the top surface are disposed facing away from each other. The first side surface is connected between the bottom surface and the top surface The electronic component is packaged inside the substrate. The electronic component may be an active component, for example, a chip, or may be a passive component, for example, a capacitor, an inductor, or a resistor. This is not limited in this application. The substrate is a carrier for packaging the electronic component, and provides the packaged electronic component with functions such as an electrical connection, protection, support, heat dissipation and assembly.

In this embodiment of this application, the electronic component package body may use a system in a package (system in package, SIP), a power supply in a package (power supply-in-package, PSiP), or an embedded chip substrate (embedded chip substrate, ECP). The system in the package integrates a plurality of functional electronic components such as a processor, a memory, and a power management chip into one package body to implement a basically complete function. The embedded chip substrate can be understood as a substrate structure in which a chip is mounted inside the substrate, the chip is packaged by using a package material, and is interconnected by using a copper hole, a copper pillar, or the like. In this embodiment, that the electronic component package body uses an embedded chip substrate is used as an example for detailed description.

The first pins are embedded in the substrate, penetrate from the bottom surface to the top surface, and are exposed on the first side surface. A part of the first pin that is exposed on the bottom surface and a part of the first pin that is exposed on the first side surface are used for soldering with solder. For example, the first pin includes a bottom surface of the first pin and a side surface of the first pin. The bottom surface of the first pin is connected to the side surface of the first pin, and an orientation of the bottom surface of the first pin is the same as an orientation of the bottom surface. The bottom surface of the first pin is exposed relative to the bottom surface, and at least a partial structure of the side surface of the first pin is exposed relative to the first side surface. The bottom surface of the first pin and the side surface of the first pin are both used for soldering with solder.

It can be understood that a partial structure of the first pin is exposed relative to the substrate, and is used to come into contact with solder to be connected to a circuit board. The side surface of the first pin can be understood as a partial structure of the first pin surrounding the side surface of the first pin. A part that is of the first pin surrounding the side surface of the first pin and whose orientation is the same as that of the first side surface is exposed relative to the first side surface. It can be understood that, one part of the first pin surrounding the side surface of the first pin is exposed relative to the first side surface, and the other part of the first pin surrounding the side surface of the first pin is located inside the substrate, so that the first pin is embedded in the substrate.

In this embodiment, both the bottom surface of the first pin and the side surface of the first pin are exposed relative to the substrate, the first pins have soldering areas of different dimensions, the first pin is a three-dimensional pin, and both the bottom surface of the first pin and the side surface of the first pin can be soldered to the solder. In this way, the soldering areas of the first pins are increased, and soldering strength of the first pins in different dimensions is also enhanced. For example, when the electronic component package body and the circuit board are assembled and soldered, solder wicking can occur on both the bottom surface of the first pin and the side surface of the first pin, so that the solder surrounds the bottom surface of the first pin and the side surface of the first pin, thereby avoiding a failure of soldering the electronic component package body and the circuit board due to long-term vibration. This improves reliability of an electronic component package assembly using the electronic component package body.

In addition, in this embodiment, the first pins are made of a metal material, the metal material has high thermal conductivity, and the first pins penetrate from the bottom surface to the top surface, so that the first pins can effectively transfer heat inside the substrate to an upper structure on the top surface or a lower structure on the bottom surface. This is conducive to transferring and diffusing the heat inside the substrate generated by the electronic component, thereby improving heat dissipation performance of the substrate.

In some possible implementations, an orientation of the side surface of the first pin is the same as an orientation of the first side surface, and the side surface of the first pin is flush with the first side surface. It can be understood that the first pin is not protruded or recessed relative to the substrate. In this embodiment, the side surface that is of the first pin and whose orientation is the same as that of the first side surface is flush with the first side surface, so that a cutting process is simple in a process of cutting an overall structure of a plurality of electronic component package bodies into a single electronic component package body.

In some possible implementations, the first pin may alternatively be recessed relative to the first side surface. In this embodiment, the first pin is recessed relative to the first side surface, and in a process of cutting a plurality of electronic component package bodies as a whole into a single electronic component package body, cutting the first pins made of a metal material can be avoided, thereby reducing cutting difficulty. In addition, the first pin is recessed relative to the first side surface, and a first soldering joint connected to a side edge of the first pin is partially embedded in the substrate, so that the first soldering joint embedded in the substrate is protected by the substrate, thereby avoiding a failure of the first soldering joint due to long-term vibration of the electronic component package assembly. This improves reliability of the electronic component package assembly.

In some possible implementations, a protective layer is disposed on an outer surface of the first pin. Oxidation resistance of a material used for the protective layer is stronger than that of the material used for the first pin. The material used for the protective layer may be but is not limited to tin. In this embodiment, the protective layer can protect the first pin, to reduce or avoid oxidation of the material used for the first pin. This is conducive to improving reliability of the electronic component package body.

In some possible implementations, the first pin may alternatively be protruded relative to the first side surface. In this embodiment, the first pin is protruded relative to the first side surface, so that an exposed area of the first pin relative to the substrate is increased, and a contact area between the first pin and the first soldering joint is further increased. In this way, stability of soldering the electronic component package body and the circuit board is further improved, thereby avoiding a failure of the soldering joint due to long-term vibration of the electronic component package assembly. This improves reliability of the electronic component package assembly.

In some possible implementations, there are a plurality of first pins, the plurality of first pins are disposed at intervals, the plurality of first pins are all located on the first side surface, and side surfaces of the plurality of first pins are all exposed relative to the first side surface. The first pins are made of a conducting material, and the first pins are disposed at intervals by using an insulating material. The insulating material may be but is not limited to a liquid photo solder resist (green oil). A person skilled in the art can design a gap between the first pins depending on an actual situation, to avoid mutual interference between adjacent pins. A quantity of first pins is corresponding to a quantity of first soldering joints.

In this embodiment, the plurality of first pins disposed at intervals are disposed on the first side surface, and a bottom surface of each first pin and a side surface of the first pin are exposed relative to the substrate. This further increases a soldering area between the electronic component package body and the circuit board. In addition, the first pins are made of a metal material, and are all located at an edge of the substrate. This is conducive to transferring and diffusing the heat inside the substrate generated by the electronic component, thereby improving heat dissipation performance of the substrate.

In some possible implementations, the substrate further includes a second side edge, a third side edge, and a fourth side edge. The third side edge and the first side surface are disposed facing away from each other, the second side edge is connected between the first side surface and the third side edge, and the fourth side edge and the second side edge are disposed facing away from each other. A plurality of first pins disposed at intervals are embedded in each of the second side edge, the third side edge, and the fourth side edge. A plurality of first pins disposed at intervals are disposed on each of the first side surface, the second side edge, the third side edge, and the fourth side edge. For example, the bottom surface of the substrate is rectangular, and the first side surface, the second side edge, the third side edge, and the fourth side edge are successively connected to jointly form a peripheral side of the substrate.

It can be understood that a plurality of first pins are embedded in any side of the peripheral side of the substrate, and at least partial structures of side surfaces of the plurality of first pins are all exposed relative to each side edge. An arrangement manner of the plurality of pins is not limited in this application, which may be a symmetrical arrangement or an asymmetrical arrangement. The plurality of first pins are symmetrically arranged along both a length direction and a width direction of the electronic component package body. In another implementation, the plurality of first pins may alternatively be asymmetrically arranged. This is not limited in this application.

In this embodiment, the plurality of first pins disposed at intervals are disposed on each side edge of the substrate, and a bottom surface of each first pin and a side surface of the first pin are exposed relative to the substrate. This further increases a soldering area between the electronic component package body and the circuit board.

In some possible implementations, the electronic component package body further includes a second pin, and the second pin is spaced from the first pins. At least a partial structure of the second pin is embedded in the substrate, the second pin is far away from the first side surface relative to the first pins, and a bottom of the second pin is used for soldering with solder.

In this embodiment, the second pin is further disposed on a bottom surface of the electronic component package body, and the second pin is also used for soldering with the solder, so that a soldering area of the electronic component package body is increased. In this way, stability of soldering the electronic component package body and another component is further improved, thereby avoiding a failure of the soldering joint due to long-term vibration. This improves reliability of the electronic component package assembly using the electronic component package body.

In some possible implementations, the second pin is electrically connected to the electronic component, to implement signal transmission between the electronic component package body and the circuit board. In another embodiment, the second pin may alternatively be non-electrically connected to the electronic component. In this case, the second pin is used to increase the soldering area of the electronic component package body and improve heat dissipation performance of the electronic component package body. It can be understood that a person skilled in the art can design a relationship between the first pins or the second pin and the electronic component based on an actual requirement of the electronic component package assembly. This is not limited in this application.

In some possible implementations, a trench is disposed on a side that is of the second pin and that faces the circuit board. The trench is recessed from a bottom surface of the first pin of the second pin towards a side of the substrate, and a partial structure of a second soldering joint is embedded in the trench. A plurality of trenches may be obtained by using a cutting method. The cutting method may be but is not limited to etching or a laser technology. It can be understood that the second soldering joint surrounds the bottom surface of the first pin of the second pin, and fills the trench. This increases a contact area between the second soldering joint and the second pin. The trench does not penetrate through the second pin. For example, there are a plurality of trenches. A recess depth of the trench is merely used as an example, and a person skilled in the art can design the recess depth based on an actual requirement.

In this embodiment, the trench is disposed on the side that is of the second pin and that faces the circuit board, so that an exposed surface area of the second pin is increased, and a soldering area of the second pin is further increased. The solder may be used to fill the trench during soldering of the electronic component package body, so that reliability of soldering the electronic component package body and the circuit board is further improved. A width, a depth, a quantity, or the like of the trench is not limited in this application. A person skilled in the art can design dimensions of the trench based on an actual requirement or a machine requirement.

According to the claimed invention, a first pad and a second pad are disposed on the top surface, the first pad is spaced from the second pad, the electronic component package body further includes a bonding wire, and the bonding wire is electrically connected between the first pad and the second pad.

Shapes, quantities, or the like of the first pad and the second pad are not limited in this application. A person skilled in the art can design the first pad and the second pad based on an actual requirement. The bonding wire may be a metal wire or a metal strip. To be specific, the pads on the top surface are bonded through wire bonding (wire bonding) and/or clip bonding (clip bonding). Quantities, locations, shapes, and the like of the first pad and the second pad on the top surface are not limited in this application. A person skilled in the art can design the quantities, locations, shapes, and the like of the first pad and the second pad based on an actual requirement.

The first pad and the second pad on the top surface are electrically connected through the bonding wire, to avoid remelting of the first pad and the second pad in a reflow soldering process when the first pad and the second pad are soldered through reflow soldering, thereby improving reliability of the electronic component package body.

According to the claimed invention, the electronic component package body further includes a package body. The package body is located on a side that is of the substrate and that is far away from the circuit board, the bonding wire is packaged inside the package body, and the package body is made of a magnetic material. For example, the magnetic material is a liquid magnetic material, and the bonding wire is packaged through glue dispensing by using the liquid magnetic material, to form the package body made of a magnetic material. A type of the magnetic material is not limited in this application, and a person skilled in the art can design the type of the magnetic material based on an actual requirement.

The pads on the top surface are electrically connected through the bonding wire, the package body made of a magnetic material is disposed on a surface of the top surface, and the package body and the bonding wire jointly form a winding of a complete magnetic element (for example, a transformer or an inductor). This can prevent an excessively high current inside the electronic component package body, and is conducive to improving reliability of the electronic component package assembly. In addition, the package body is seamlessly connected to the top surface, to facilitate heat dissipation of each electronic component in a package layer, thereby improving heat dissipation performance of the electronic component package body.

An appearance of a microscopic insulating material inside the magnetic material is not conductive, and the package body made of a magnetic material is not electrically connected to the bonding wire. For example, an internal part of the bonding wire is made of a metal material, and an external part of the bonding wire is wrapped by using an insulating material, to avoid mutual interference between the bonding wire and the package body.

According to the claimed invention, the package body covers a partial region of the top surface, and an edge of the top surface is exposed relative to the package body. It can be understood that an area of a projection of the package body onto the circuit board is less than an area of a projection of the substrate onto the circuit board, and the projection of the package body is located inside the projection of the substrate.

The surface area of the package body made of a magnetic material is less than a surface area of the substrate, the package body covers a partial structure of the substrate, and the edge of the substrate is exposed relative to the package body. Cutting the overall structure of the plurality of electronic component package bodies into the single electronic component package body can be implemented only by cutting the edge of the substrate, without cutting the package body. This avoids increasing cutting difficulty caused by cutting the package body, and reduces costs of the electronic component package body. It can be understood that the package body is made of a magnetic material, and the cutting difficulty of the magnetic material is high. In this application, an area of the package body is designed to be small, so that a structure of the edge of the substrate is exposed relative to the package body, thereby reducing the cutting difficulty.

In some possible implementations, the electronic component package assembly further includes an element. The element is located on a side that is of the top surface and that is far away from the bottom surface, and the element is packaged inside the package body. For example, there are a plurality of elements, and the plurality of elements are disposed at intervals. A type of the element is not limited in this application. A person skilled in the art can design the type of the element based on an actual requirement. For example, the element may be an active component, for example, a chip, or may be a passive component, for example, a capacitor, an inductor, or a resistor.

In this embodiment, a plurality of electronic components are disposed inside the substrate, and the plurality of elements are disposed outside the substrate, to satisfy different requirements of the electronic component package body. For example, when a thickness of the electronic component is greater than or equal to that of the substrate, the electronic component may be placed outside the substrate. In addition, the plurality of elements are packaged inside the package body, and provide the packaged elements with functions such as an electrical connection, protection, support, heat dissipation, and assembly.

In some possible implementations, a groove is disposed in the package body, the element is accommodated in the groove, and the element is exposed relative to the package body. For example, there are a plurality of grooves. A plurality of elements are disposed in one groove.

In this embodiment, the groove for accommodating the element is disposed in the package body, and the element is exposed relative to the package body. The package body may reserve a surface mount region of the element, to facilitate an electrical connection between the element and another component. It can be understood that a person skilled in the art can design a location of the element relative to the package body based on an actual requirement. The element may be exposed relative to the package body, or may be embedded inside the package body.

According to a second aspect, this application provides an electronic component package assembly. The electronic component package assembly includes a circuit board, a first soldering joint, and the foregoing electronic component package body. The electronic component package body is mounted on the circuit board. The first soldering joint is connected between the electronic component package body and the circuit board. The part of the first pin that is exposed on the bottom surface and the part of the first pin that is exposed on the first side surface are soldered at the first soldering joint. It can be understood that the first soldering joint surrounds a region that is of the first pin and that is exposed relative to the substrate, for example, the bottom surface of the first pin and the side surface of the first pin.

In this embodiment, both the bottom surface of the first pin and the side surface of the first pin are exposed relative to the substrate, the first pins have soldering areas of different dimensions, the first pin is a three-dimensional pin soldered to the circuit board, and the first soldering joint can be connected to the bottom surface of the first pin and can also be connected to the side surface of the first pin. In this way, the soldering areas of the first pins are increased, and soldering strength of the first pins in different dimensions is also enhanced, thereby avoiding a failure of soldering the electronic component package body and the circuit board due to long-term vibration of the electronic component package assembly. This improves reliability of the electronic component package assembly. When the electronic component package body and the circuit board are assembled and soldered, solder wicking can occur on both the bottom surface of the first pin and the side surface of the first pin, so that the first soldering joint surrounds the bottom surface of the first pin and the side surface of the first pin.

In addition, in this embodiment, the first pins are made of a metal material, the metal material has high thermal conductivity, and the first pins penetrate from the bottom surface to the top surface, so that the first pins can effectively transfer heat inside the substrate to an upper structure on the top surface or a lower structure on the bottom surface. This is conducive to transferring and diffusing the heat inside the substrate generated by the electronic component, thereby improving heat dissipation performance of the substrate.

In some possible implementations, a main material used for the first pin is different from a material used for the first soldering joint, and a melting point of the main material used for the first pin is higher than a melting point of a tin material. For example, the material used for the first soldering joint includes tin. The main material used for the first pin may be but is not limited to copper.

In this embodiment, the melting point of the main material used for the first pin is higher than the melting point of the material used for the first soldering joint, and the first pin is not remelted in a process of soldering the electronic component package body and the circuit board, so that the first soldering joint effectively wraps the bottom surface of the first pin and the side surface of the first pin, thereby improving reliability of soldering the electronic component package body and the circuit board. Remelting is a secondary melting process of a metal or an alloy. It can be understood that, in a process of soldering the first pin and the circuit board, secondary melting does not occur in a main part of the first pin, and a general shape of the main part of the first pin does not change, to ensure that the material of the molten first soldering joint surrounds the exposed parts of the first pin.

In some possible implementations, the first soldering joint includes an integrally formed first segment and second segment. The first segment is connected between the circuit board and the part of the first pin that is exposed on the bottom surface, and the second segment is connected between the circuit board and the part of the first pin that is exposed on the first side surface. For example, the first segment is connected between the bottom surface of the first pin and the circuit board, and the second segment surrounds a periphery of the side surface of the first pin. A partial structure that is of the side surface of the first pin and that is far away from the bottom surface of the first pin is exposed relative to the second segment. To be specific, a partial structure of the side surface of the first pin is surrounded by the first soldering joint, and the other partial structure of the side surface of the first pin is exposed relative to the first soldering joint.

In this embodiment, only the partial structure of the side surface of the first pin is surrounded by the first soldering joint, and the other partial structure of the side surface of the first pin is exposed relative to the first soldering joint. This facilitates heat dissipation inside the substrate, thereby improving heat dissipation performance of the electronic component package body.

In another embodiment, the first soldering joint may alternatively surround an entire outer surface that is of the first pin and that is exposed relative to the substrate. In other words, the second segment wraps an entire outer surface of the side surface of the first pin. It can be understood that, a height of the side surface that is of the first pin and that is surrounded by the first soldering joint is not limited in this application. A person skilled in the art can design the height based on an actual requirement.

In some possible implementations, the electronic component package body further includes a second soldering joint. The second soldering joint is connected between the second pin and the circuit board. The second soldering joint is made of a conducting material. The material used for the second soldering joint may be the same as the material used for the first soldering joint. For example, the first pins are located at the edge of the substrate, and the second pin is located in a middle region of the substrate.

In this embodiment, the second pin is further disposed on a side that is of the electronic component package body and that faces the circuit board, and the second pin is soldered to the second soldering joint, so that a soldering area between the electronic component package body and the circuit board is increased. In this way, stability of soldering the electronic component package body and the circuit board is further improved, thereby avoiding a failure of the soldering joint due to long-term vibration of the electronic component package assembly. This improves reliability of the electronic component package assembly.

According to a third aspect, this application further provides an electronic device. The electronic device includes a housing and the foregoing electronic component package assembly, where the electronic component package assembly is mounted on the housing.

In this embodiment of this application, at least some pins of the electronic component package body in the electronic device have soldering areas of different dimensions, so that reliability of soldering the electronic component package body and the circuit board is improved, and a risk of a failure of soldering the electronic component package body and the circuit board due to long-term vibration of the electronic component package assembly in the electronic device is reduced. This effectively improves board-level reliability of the electronic component package assembly, thereby improving reliability of the electronic device. For example, when the electronic device is a car with a high vehicle specification level, the electronic device encounters more vibration and impact when working in a moving environment. In this case, reliability of soldering the electronic component package body and the circuit board in the electronic device is high, and a possibility of a failure of soldering the electronic component package body and the circuit board is low. This ensures reliability of the electronic device.

### BRIEF DESCRIPTION OF DRAWINGS

To describe technical solutions in embodiments of this application or in the background, the following describes accompanying drawings for describing the embodiments of this application or the background.
FIG. 1 is a schematic diagram of a structure of an electronic component package assembly according to an embodiment of this application;
FIG. 2 is a partial side view of the electronic component package assembly shown in FIG. 1;
FIG. 3 is a side view of the electronic component package body shown in FIG. 2;
FIG. 4 is a bottom view of the electronic component package body shown in FIG. 3;
FIG. 5 is a schematic partial cross-sectional view of the electronic component package assembly shown in FIG. 1;
FIG. 6a is a schematic partial cross-sectional view of an electronic component package assembly according to Embodiment 2 of this application;
FIG. 6b is a schematic partial cross-sectional view of the electronic component package body shown in FIG. 6a;
FIG. 7 is a top view of the electronic component package assembly shown in FIG. 6a;
FIG. 8 is a top view of an electronic component package assembly according to Embodiment 3 of this application;
FIG. 9a is a schematic partial cross-sectional view of the electronic component package assembly shown in FIG. 8;
FIG. 9b is a schematic partial cross-sectional view of the electronic component package body shown in FIG. 9a;
FIG. 10 is a top view of an electronic component package assembly according to Embodiment 4 of this application;
FIG. 11a is a schematic partial cross-sectional view of the electronic component package assembly shown in FIG. 10;
FIG. 11b is a schematic partial cross-sectional view of the electronic component package body shown in FIG. 11a;
FIG. 12a is a schematic partial cross-sectional view of an electronic component package assembly according to Embodiment 5 of this application;
FIG. 12b is a schematic partial cross-sectional view of the electronic component package body shown in FIG. 12a;
FIG. 13 is a bottom view of the electronic component package body shown in FIG. 12b; and
FIG. 14 is an enlarged schematic diagram of a structure of a part a shown in FIG. 12a.

### DESCRIPTION OF EMBODIMENTS

The following describes embodiments of this application with reference to accompanying drawings in the embodiments of this application.

This application provides an electronic device. The electronic device includes a housing and an electronic component package assembly. The electronic component package assembly is mounted on the housing. The electronic device may be a product, for example, a mobile phone, a tablet computer, a notebook computer, a vehicle-mounted device, a wearable device, a drone, or a router. The electronic device may alternatively be a device, for example, a power supply module or a network switch device. In this embodiment, an example in which the electronic device is a vehicle-mounted device is used for description.

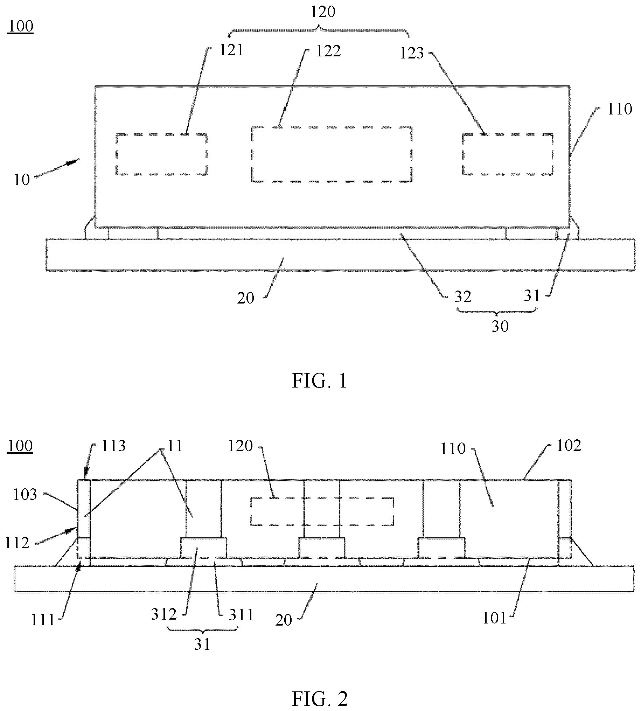

FIG. 1 is a schematic diagram of a structure of an electronic component package assembly 100 according to an embodiment of this application. The electronic component package assembly 100 includes an electronic component package body 10, a circuit board 20, and soldering joints 30 connected between the electronic component package body 10 and the circuit board 20. For example, the soldering joints 30 include a first soldering joint 31 and a second soldering joint 32 spaced from each other. The electronic component package body 10 is mounted on the circuit board 20. The electronic component package body 10 includes a substrate 110 and an electronic component 120 packaged inside the substrate 110. The electronic component 120 may be an active component, for example, a chip, or may be a passive component, for example, a capacitor, an inductor, or a resistor.

A person skilled in the art can select a type of the electronic component 120, a quantity of electronic components 120, or the like based on an actual requirement. This is not limited in this application. The substrate 110 is a carrier for packaging the electronic component 120, and provides the packaged electronic component 120 with functions such as an electrical connection, protection, support, heat dissipation, and assembly. A quantity of electronic components 120, a size of the electronic component 120, or the like in FIG. 1 is merely used as an example. It can be understood that the electronic component 120 cannot be observed from an outer surface of the electronic component package body 10. The electronic component 120 is illustrated by dashed lines in FIG. 1.

In some embodiments, there are a plurality of electronic components 120. As shown in FIG. 1, for example, the electronic component 120 includes a first component 121, a second component 122, and a third component 123. The second component 122 is spaced between the first component 121 and the third component 123. In some possible implementations, the second component 122 is a chip, the first component 121 is a resistor, and the second component 122 is a capacitor. In another embodiment, the first component 121, the second component 122, or the third component 123 may alternatively be another active component or passive component. This is not limited in this application. A person skilled in the art can design the first component 121, the second component 122, or the third component 123 based on an actual requirement.

In this embodiment of this application, the electronic component package body 10 may use a system in a package (system in package, SIP), a power supply in a package (power supply-in-package, PSiP), or an embedded chip substrate (embedded chip substrate, ECP). The system in the package integrates a plurality of functional electronic components such as a processor, a memory, and a power management chip into one package body to implement a basically complete function. The embedded chip substrate can be understood as a substrate structure in which a chip is mounted inside the substrate, the chip is packaged by using a package material, and is interconnected by using a copper hole, a copper pillar, or the like. In this embodiment, that the electronic component package body 10 uses an embedded chip substrate is used as an example for detailed description.

The circuit board 20 is electrically connected to the electronic component package body 10 through soldering by using the soldering joints 30, to be electrically interconnected with the electronic component package body 10. The circuit board 20 can also be understood as a carrier for the electronic component package body 10, and can carry the electronic component package body 10 and can be assembled together with the electronic component package body 10. In this embodiment of this application, an example in which the electronic component package body 10 is mounted on the circuit board 20 is used for description. In another embodiment, the electronic component package body 10 may alternatively be mounted in another structure. This is not limited in this application.

It should be noted that FIG. 1 is merely used to schematically describe a connection relationship between the circuit board 20 and the electronic component package body 10, and is not used to specifically limit connection locations, specific conformations, and quantities of the devices. The structure described in this embodiment of this application constitutes no specific limitation on the electronic component package assembly 100. In some other embodiments of this application, the electronic component package assembly 100 may include more components than those shown in the figure, a combination of some components, splitting of some components, or a different arrangement of the components. The components shown in the figure may be implemented by hardware, software, or a combination of software and hardware.

In a conventional technology, the electronic component package body and the circuit board are soldered in a land grid array (land grid array, LGA) manner. The land grid array is surface-mount packaging. Reliability of soldering the electronic component package body and the circuit board is poor. In a scenario of long-term mechanical vibration or impact of temperature change, an electronic device has a risk of an electrical failure due to unsteady soldering. For example, pins of the electronic component package body are flush with the outer surface of the electronic component package body, and a surface of the circuit board is attached to the surface of the electronic component package body to connect the pins of the electronic component package body and corresponding pins of the circuit board. A fatigue failure occurs on a soldering joint between the electronic component package body and the circuit board during long-term mechanical vibration of the electronic device, and then the soldering joint breaks, affecting reliability of the electronic device.

In view of this, this application provides an electronic component package body 10. At least some pins of the electronic component package body 10 have soldering areas of different dimensions, so that reliability of soldering the electronic component package body 10 and the circuit board 20 is improved, and a risk of a failure of soldering the electronic component package body 10 and the circuit board 20 due to long-term vibration of the electronic component package assembly 100 is reduced. This effectively improves board-level reliability of the electronic component package assembly 100. For example, when the electronic component package assembly 100 is used for a car with a high vehicle specification level, the car encounters more vibration and impact when working in a moving environment. In this case, the electronic component package assembly 100 in which reliability of soldering the electronic component package body 10 and the circuit board 20 is high is used, so that reliability of the car is ensured.

The following mainly uses five embodiments to specifically describe the electronic component package assembly 100 and the corresponding electronic component package body 10 that are provided in this application.

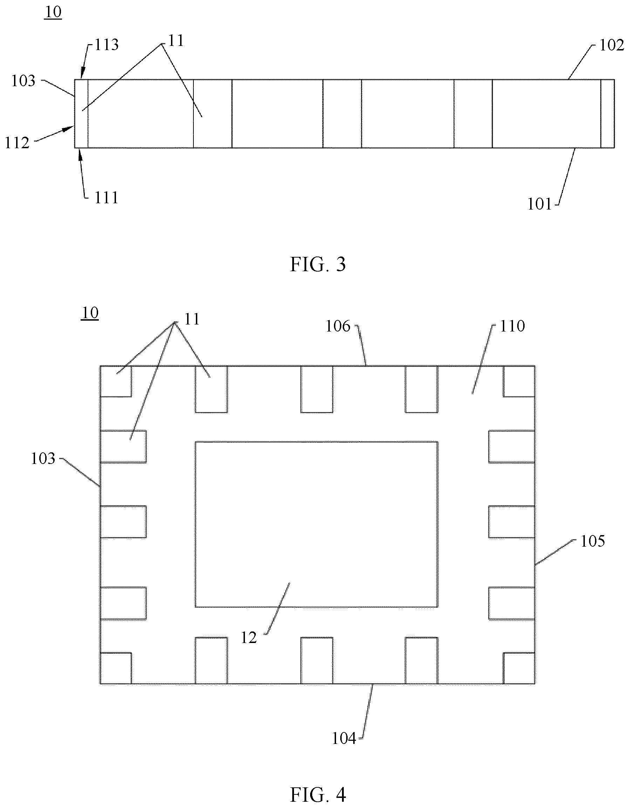

FIG. 2 is a partial side view of the electronic component package assembly 100 shown in FIG. 1. FIG. 3 is a side view of the electronic component package body 10 shown in FIG. 2. FIG. 2 illustrates a side-edge structure of the electronic component package assembly 100 in more detail than FIG. 1. The substrate 110 includes a bottom surface 101, a top surface 102, and a first side surface 103. The bottom surface 101 and the top surface 102 are disposed facing away from each other. The first side surface 103 is connected between the bottom surface 101 and the top surface 102. The bottom surface 101 faces the circuit board 20. The electronic component is located between the bottom surface 101 and the top surface 102. For example, the substrate 110 is substantially rectangular and is a hexahedron. The first side surface 103 is only a side edge in one direction in a peripheral side of the substrate 110.

The electronic component package body 10 includes first pins 11. The first pins 11 are embedded in the substrate 110, and the first pins 11 are exposed relative to the bottom surface 101 and are exposed relative to the first side surface 103. A part of the first pin 11 that is exposed on the bottom surface 101 and a part of the first pin 11 that is exposed on the first side surface 103 are used for soldering with solder.

For example, the first pin 11 includes a bottom surface 111 of the first pin 11 and a side surface 112 of the first pin 11. The bottom surface 111 of the first pin 11 is connected to the side surface 112 of the first pin, and an orientation of the bottom surface 111 of the first pin 11 is the same as an orientation of the bottom surface 101. The bottom surface 111 of the first pin 11 is disposed opposite to the circuit board 20. The bottom surface 111 of the first pin 11 is exposed relative to the bottom surface 101, and at least a partial structure of the side surface 112 of the first pin 11 is exposed relative to the first side surface 103. The electronic component package assembly 100 includes the first soldering joint 31. The part of the first pin 11 that is exposed on the bottom surface 101 and the part of the first pin 11 that is exposed on the first side surface 103 are soldered at the first soldering joint 31. For example, the first soldering joint 31 surrounds the bottom surface 111 of the first pin 11 and the side surface 112 of the first pin 11. It can be understood that a partial structure of the first pin 11 is exposed relative to the substrate 110, and is used to come into contact with the first soldering joint 31, so that the first soldering joint 31 is connected to the electronic component package body and the circuit board 20.

The side surface 112 of the first pin 11 can be understood as a partial structure of the first pin 11 surrounding the side surface of the first pin. A part that is of the first pin 11 surrounding the side surface of the first pin and whose orientation is the same as that of the first side surface 103 is exposed relative to the first side surface 103. It can be understood that, one part of the first pin 11 surrounding the side surface of the first pin is exposed relative to the first side surface 103, and the other part of the first pin 11 surrounding the side surface of the first pin is located inside the substrate 110, so that the first pin 11 is embedded in the substrate 110. The first soldering joint 31 surrounds a region that is of the first pin 11 and that is exposed relative to the substrate 110, for example, the bottom surface 111 of the first pin 11 and the side surface 112 of the first pin 11.

In this embodiment, both the bottom surface 111 of the first pin 11 and the side surface 112 of the first pin 11 are exposed relative to the substrate 110, the first pins 11 have soldering areas of different dimensions, the first pin 11 is a three-dimensional pin soldered to the circuit board 20, and the first soldering joint 31 can be connected to the bottom surface 111 of the first pin 11 and can also be connected to the side surface 112 of the first pin 11. In this way, the soldering areas of the first pins 11 are increased, and soldering strength of the first pins 11 in different dimensions is also enhanced, thereby avoiding a failure of soldering the electronic component package body 10 and the circuit board 20 due to long-term vibration of the electronic component package assembly 100. This improves reliability of the electronic component package assembly 100. When the electronic component package body 10 and the circuit board 20 are assembled and soldered, solder wicking can occur on both the bottom surface 111 of the first pin 11 and the side surface 112 of the first pin 11, so that the first soldering joint 31 surrounds the bottom surface 111 of the first pin 11 and the side surface 112 of the first pin 11.

In addition, in this embodiment, the first pins 11 are made of a metal material, the metal material has high thermal conductivity, and the side surface 112 of the first pin 11 is exposed relative to the substrate 110. This is conducive to transferring and diffusing heat inside the substrate 110 generated by the electronic component 120, thereby improving heat dissipation performance of the substrate 110.

It can be understood that, in this application, the soldering areas of the first pins 11 in the electronic component package body 10 are increased, and a quantity of pads that are on the circuit board 20 and to which the electronic component package body 10 is soldered is also appropriately increased, to match the soldering of the first pin 11. A specific structure, form, or the like of the circuit board 20 is not limited in this application. A person skilled in the art can solder the circuit board 20 and the electronic component package body 10 based on an actual requirement.

In some embodiments, the first pins 11 penetrate from the bottom surface 101 to the top surface 102. In other words, the first pins 11 penetrate through the substrate 110. It can be understood that the first pin 11 further includes a top surface 113 that is of the first pin 11 and that is disposed facing away from the bottom surface 111 of the first pin 11. The top surface 113 of the first pin 11 is exposed relative to the top surface 102. Both the first pin 11 and the first soldering joint 31 are made of metal materials, to implement an electrical connection between the first pin 11 and the circuit board 20. The first pins 11 may penetrate from the bottom surface 101 to the top surface 102 vertically or in a bent manner. This is not limited in this application. For example, a structure of the substrate 110 is similar to a multilayer stack structure of the circuit board 20, and the first pin 11 is bent after passing through each layer of structure, to form a pin penetrating from the bottom surface 101 to the top surface 102.

In this embodiment, the first pins 11 are made of a metal material, the metal material has high thermal conductivity, and the first pins 11 penetrate from the bottom surface 101 to the top surface 102, so that the first pins 11 can effectively transfer heat inside the substrate 110 to an upper structure on the top surface 102 or a lower structure on the bottom surface 101. This is conducive to transferring and diffusing the heat inside the substrate 110 generated by the electronic component 120, thereby improving heat dissipation performance of the substrate 110.

In some embodiments, a main material used for the first pin 11 is different from a material used for the first soldering joint 31, and a melting point of the main material used for the first pin 11 is higher than a melting point of a tin material. For example, the material used for the first soldering joint 31 includes tin. The main material used for the first pin 11 may be but is not limited to copper.

In this embodiment, the melting point of the main material used for the first pin 11 is higher than the melting point of the material used for the first soldering joint 31, and the first pin 11 is not remelted in a process of soldering the electronic component package body 10 and the circuit board 20, so that the first soldering joint 31 effectively wraps the bottom surface 111 of the first pin 11 and the side surface 112 of the first pin 11, thereby improving reliability of soldering the electronic component package body 10 and the circuit board 20. Remelting is a secondary melting process of a metal or an alloy. It can be understood that, in a process of soldering the first pin 11 and the circuit board 20, secondary melting does not occur in a main part of the first pin 11, and a general shape of the main part of the first pin 11 does not change, to ensure that the material of the molten first soldering joint 31 surrounds the exposed parts of the first pin 11.

FIG. 4 is a bottom view of the electronic component package body 10 shown in FIG. 3. There are a plurality of first pins 11, the plurality of first pins 11 are disposed at intervals, the plurality of first pins 11 are all located on the first side surface 103, and side surfaces 112 of the plurality of first pins 11 are all exposed relative to the first side surface 103. The first pins 11 are made of a conducting material, and the first pins 11 are disposed at intervals by using an insulating material. The insulating material may be but is not limited to a liquid photo solder resist (green oil). A person skilled in the art can design a gap between the first pins 11 depending on an actual situation, to avoid mutual interference 3 between adjacent pins. A quantity of first pins 11 is corresponding to a quantity of first soldering joints 31.

In this embodiment, the plurality of first pins 11 disposed at intervals are disposed on the first side surface 103, and a bottom surface 111 of each first pin 11 and a side surface 112 of the first pin 11 are exposed relative to the substrate 110. This further increases a soldering area between the electronic component package body 10 and the circuit board 20. In addition, the first pins 11 are made of a metal material, and are all located at an edge of the substrate 110. This is conducive to transferring and diffusing the heat inside the substrate 110 generated by the electronic component 120, thereby improving heat dissipation performance of the substrate 110.

For example, the substrate 110 further includes a second side edge 104, a third side edge 105, and a fourth side edge 106. The third side edge 105 and the first side surface 103 are disposed facing away from each other, the second side edge 104 is connected between the first side surface 103 and the third side edge 105, and the fourth side edge 106 and the second side edge 104 are disposed facing away from each other. A plurality of first pins 11 disposed at intervals are embedded in each of the second side edge 104, the third side edge 105, and the fourth side edge 106. A plurality of first pins 11 disposed at intervals are disposed on each of the first side surface 103, the second side edge 104, the third side edge 105, and the fourth side edge 106. As shown in FIG. 4, the bottom surface 101 of the substrate 110 is rectangular, and the first side surface 103, the second side edge 104, the third side edge 105, and the fourth side edge 106 are successively connected to jointly form a peripheral side of the substrate 110.

It can be understood that a plurality of first pins 11 are embedded in any side of the peripheral side of the substrate 110, and at least partial structures of side surfaces 112 of the plurality of first pins 11 are all exposed relative to each side edge. An arrangement manner of the plurality of pins is not limited in this application, which may be a symmetrical arrangement or an asymmetrical arrangement. The plurality of first pins 11 are symmetrically arranged along both a length direction and a width direction of the electronic component package body 10. In another implementation, the plurality of first pins 11 may alternatively be asymmetrically arranged. This is not limited in this application.

In this embodiment, the plurality of first pins 11 disposed at intervals are disposed on each side edge of the substrate 110, and a bottom surface 111 of each first pin 11 and a side surface 112 of the first pin 11 are exposed relative to the substrate 110. This further increases a soldering area between the electronic component package body 10 and the circuit board 20.

As shown in FIG. 4, side surfaces of two adjacent first pins in the first pins 11 at four diagonal corners of the substrate 110 are exposed relative to the substrate 110. A quantity of first pins 11 in FIG. 4 is merely used as an example, and is not limited in this application. A person skilled in the art can adjust, that is, increase or decrease, the quantity of the first pins 11 based on a requirement of the electronic component package assembly 100. For example, in some embodiments, there are four first pins 11, and the four first pins 11 are distributed at the four diagonal corners of the substrate in a one-to-one correspondence manner.

In some embodiments, at least one of the plurality of first pins 11 is electrically connected to the electronic component 120, and is electrically connected to the circuit board 20 through a corresponding first soldering joint 31. A signal generated through processing in the electronic component package body 10 sequentially passes through the first pin 11, the first soldering joint 31, the circuit board 20, and a corresponding working module. Alternatively, a signal generated by a working module electrically connected to the circuit board 20 is transmitted to the electronic component package body 10 sequentially through the circuit board 20 and the first pin 11. This implements communication between the electronic component package body 10 and the corresponding working module.

It can be understood that at least one of the plurality of first pins 11 may be non-electrically connected to the electronic component 120. In this case, the first pin 11 does not need to implement electrical signal transmission, and may only be used to increase a soldering area of the electronic component package body 10 or improve heat dissipation performance of the electronic component package body 10. The first pins 11 are made of a metal material that has higher thermal conductivity compared with the insulating material, and therefore overall heat dissipation performance of the electronic component package body 10 is better improved. An electrical connection relationship between the plurality of first pins 11 and the electronic component 120 is not limited in this application. A person skilled in the art can design this electrical connection relationship based on an actual requirement. For example, some first pins 11 are electrically connected to the electronic component 120 to implement signal transmission, while some other first pins 11 are non-electrically connected to the electronic component and are only used to improve the overall heat dissipation performance of the substrate 110.

In this embodiment of this application, the first pin 11 may be electrically connected to the electronic component 120, or may be non-electrically connected to the electronic component 120. It can be understood that the first pin 11 may be used to be electrically connected to another component, or may only be used to increase a soldering area between the electronic component package body 10 and the circuit board 20 or increase heat dissipation performance of the electronic component package body 10. A person skilled in the art can design a function of the first pin 11 based on an actual requirement.

Still refer to FIG. 3 and FIG. 4. In some embodiments, an orientation of the side surface 112 of the first pin 11 is the same as an orientation of the first side surface 103, and the side surface 112 of the first pin 11 is flush with the first side surface 103. It can be understood that the first pin 11 is not protruded or recessed relative to the substrate 110. In this embodiment, the side surface 112 that is of the first pin 11 and whose orientation is the same as that of the first side surface 103 is flush with the first side surface 103, so that a cutting process is simple in a process of cutting an overall structure of a plurality of electronic component package bodies 10 into a single electronic component package body 10.

In some other embodiments, the first pin 11 may alternatively be recessed relative to the first side surface 103. In this embodiment, the first pin 11 is recessed relative to the first side surface 103, and in a process of cutting an overall structure of a plurality of electronic component package bodies 10 into a single electronic component package body 10, cutting the first pins 11 made of a metal material can be avoided, thereby reducing overall cutting difficulty. In addition, the first pin 11 is recessed relative to the first side surface 103, and a first soldering joint 31 connected to a side edge of the first pin 11 is partially embedded in the substrate 110, so that the first soldering joint 31 embedded in the substrate 110 is protected by the substrate 110, thereby avoiding a failure of the first soldering joint 31 due to long-term vibration of the electronic component package assembly 100. This improves reliability of the electronic component package assembly 100.

In some other embodiments, the first pin 11 may alternatively be protruded relative to the first side surface 103. In this embodiment, the first pin 11 is protruded relative to the first side surface 103, so that an exposed area of the first pin 11 relative to the substrate 110 is increased, and a contact area between the first pin 11 and the first soldering joint 31 is further increased. In this way, stability of soldering the electronic component package body 10 and the circuit board 20 is further improved, thereby avoiding a failure of the soldering joint due to long-term vibration of the electronic component package assembly 100. This improves reliability of the electronic component package assembly 100.

It can be understood that, the first pin 11 may be flush with the first side surface 103, the first pin 11 may be recessed relative to the first side surface 103, or the first pin 11 may be protruded relative to the first side surface 103. A person skilled in the art can design a location relationship between the first pin 11 and the first side surface 103 based on an actual requirement. This is not limited in this application.

In some embodiments, a protective layer is disposed on an outer surface of the first pin 11 (not shown in the figure). Oxidation resistance of a material used for the protective layer is stronger than that of the material used for the first pin 11. The material used for the protective layer may be but is not limited to tin.

In this embodiment, the protective layer disposed on the outer surface of the first pin 11 can protect the first pin, to reduce or avoid oxidation of the material used for the first pin 1. This is conducive to improving reliability of the electronic component package body 10.

With reference to FIG. 1 and FIG. 4, the electronic component package assembly 100 further includes a second pin 12 and the second soldering joint 32. The second pin 12 is spaced from the first pins 11. At least a partial structure of the second pin 12 is embedded in the substrate 110, and the second pin 12 is far away from the first side surface 103 relative to the first pins 11. It can be understood that the soldering joints 30 include the first soldering joint 31 and the second soldering joint 32. The second soldering joint 32 is connected between the second pin 12 and the circuit board 20. The second soldering joint 32 is made of a conducting material. The material used for the second soldering joint 32 may be the same as the material used for the first soldering joint 31. For example, the first pins 11 are located at the edge of the substrate 110, and the second pin 12 is located in a middle region of the substrate 110. A location, a quantity, a shape, a size, or the like of the second pin 12 in FIG. 4 is merely used as an example, and is not limited in this application. In another embodiment, there may alternatively be a plurality of second pins 12, and the plurality of second pins 12 are disposed at intervals. This is not limited in this application.

In this embodiment, the second pin 12 is further disposed on a side that is of the electronic component package body 10 and that faces the circuit board 20, and the second pin 12 is soldered to the second soldering joint 32, so that the soldering area between the electronic component package body 10 and the circuit board 20 is increased. In this way, stability of soldering the electronic component package body 10 and the circuit board 20 is further improved, thereby avoiding a failure of the soldering joint due to long-term vibration of the electronic component package assembly 100. This improves reliability of the electronic component package assembly 100.

In some embodiments, the second pin 12 is electrically connected to the electronic component 120, to implement signal transmission between the electronic component package body 10 and the circuit board 20. In another embodiment, the second pin 12 may alternatively be non-electrically connected to the electronic component 120. In this case, the second pin 12 is used to increase the soldering area between the electronic component package body 10 and the circuit board 20 and improve stability of connecting the electronic component package body 10 and the circuit board 20.

It can be understood that a person skilled in the art can design a relationship between the first pins 11 or the second pin 12 and the electronic component 120 based on an actual requirement of the electronic component package assembly 100. This is not limited in this application. The first soldering joint 31 or the second soldering joint 32 may be used to implement an electrical connection between the electronic component package body 10 and the circuit board 20.

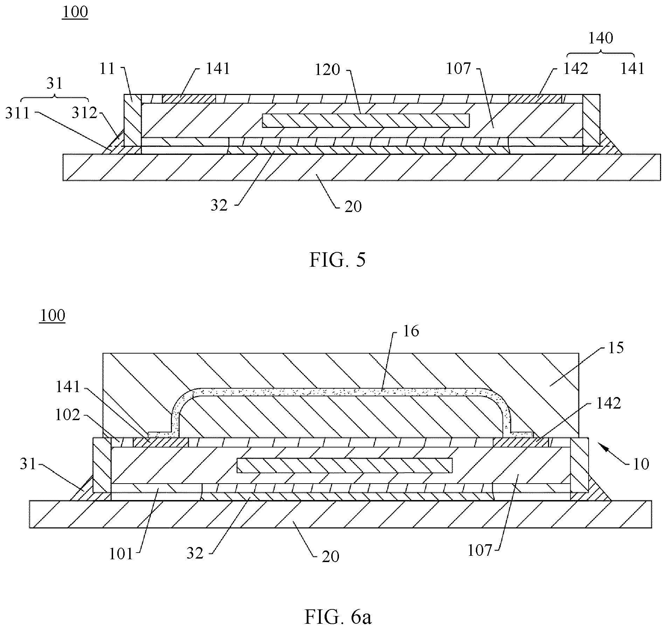

FIG. 5 is a schematic partial cross-sectional view of the electronic component package assembly shown in FIG. 1. The substrate 110 further includes a package layer 107 located between the bottom surface 101 and the top surface 102. The electronic component 120 is packaged inside the package layer 107. The bottom surface 101 and the top surface 102 may be considered as circuit layers outside the substrate 110. The package layer 107 is located between the bottom surface 101 and the top surface 102. It can be understood that the substrate 110 is of a multilayer structure. FIG. 5 only shows that the top surface 102, the package layer 107, and the bottom surface 101 are sequentially disposed in a stacked manner. The substrate 110 may be of a structure with more layers. This is not limited in this application. The layer structure of the substrate 110 may be but is not limited to a layer structure similar to that of the circuit board 20. A specific structure of the package layer 107 is not limited in this application. A person skilled in the art can design this specific structure based on an actual requirement.

It can be understood that the bottom surface 101 further includes an insulating material, and the insulating material is spaced between the plurality of first pins 11 and the second pin 12. A technology for forming the first pins 11 or the second pin 12 in the electronic component package body 10 may be an etching technology, a laser soldering technology, or the like. A person skilled in the art can design the technology for forming the first pins 11 or the second pin 12 based on an actual requirement. For example, the bottom surface 101 is first etched to form a patterned bottom surface 101, and the patterned bottom surface 101 is filled with a conducting material to form the first pins 11 or the second pin 12.

Refer to FIG. 2 and FIG. 5. The first soldering joint 31 includes an integrally formed first segment 311 and second segment 312. The first segment 311 is connected between the circuit board 20 and the part of the first pin 11 that is exposed on the bottom surface 101, and the second segment 312 is connected between the circuit board 20 and the part of the first pin 11 that is exposed on the first side surface 103. For example, the first segment 311 is connected between the bottom surface 111 of the first pin 11 and the circuit board 20, and the second segment 312 surrounds a periphery of the side surface 112 of the first pin 11. As shown in FIG. 2 or FIG. 5, for example, a partial structure that is of the side surface 112 of the first pin 11 and that is far away from the bottom surface 111 of the first pin 11 is exposed relative to the second segment 312. To be specific, a partial structure of the side surface 112 of the first pin 11 is surrounded by the first soldering joint 31, and the other partial structure of the side surface 112 of the first pin 11 is exposed relative to the first soldering joint 31.

In this embodiment, only the partial structure of the side surface 112 of the first pin 11 is surrounded by the first soldering joint 31, and the other partial structure of the side surface 112 of the first pin 11 is exposed relative to the first soldering joint 31. This facilitates heat dissipation inside the substrate 110, thereby improving heat dissipation performance of the electronic component package body 10.

In another embodiment, the first soldering joint 31 may alternatively surround an entire outer surface that is of the first pin 11 and that is exposed relative to the substrate 110. In other words, the second segment 312 wraps an entire outer surface of the side surface 112 of the first pin 11. It can be understood that, a height of the side surface 112 that is of the first pin 11 and that is surrounded by the first soldering joint 31 is not limited in this application. A person skilled in the art can design the height based on an actual requirement or a technical skill.

As shown in FIG. 5, in this embodiment, that a surface that is of the first pin 11 or the second pin 12 and that faces the circuit board 20 is flush with the bottom surface 101 is used as an example for description. In another embodiment, a surface that is of the first pin 11 or the second pin 12 and that faces the circuit board 20 may alternatively be recessed or protruded relative to the bottom surface 101. This is not limited in this application. For example, the first pin 11 includes a first portion and a second portion integrally formed with the first portion. The first portion is embedded in the bottom surface 101, and the second portion is protruded relative to the bottom surface 101. It can be understood that the second portion is protruded relative to the bottom surface 101, the second portion is a three-dimensional pin, both the bottom surface 111 of the first pin 11 and the side surface of the first pin in the second portion are exposed relative to the substrate 110, and the first soldering joint 31 may surround the bottom surface 111 of the first pin 11 and the side surface of the first pin in the second portion. In this way, the soldering areas of the first pins 11 are increased, and soldering strength of the first pins 11 in different dimensions is also enhanced. This improves reliability of soldering the electronic component package body 10 and the circuit board 20.

Still refer to FIG. 5. In some embodiments, a side that is of the substrate 110 and that faces away from the circuit board 20 includes pads 140. The pads 140 are embedded on the top surface 102. The top surface 102 includes a plurality of pads 140 provided for electrical connections. Shapes, a quantity, or the like of the pads 140 in FIG. 5 is merely used as an example, and is not limited in this application. For example, the pads 140 include a first pad 141 and a second pad 142. Pattern designs of the top surface 102 and the bottom surface 101 may be differentiated, that is, the pattern designs of the top surface 102 and the bottom surface 101 may be different. This is not strictly limited in this embodiment of this application. Both the pattern design of the top surface 102 and the pattern design of the bottom surface 101 may be made based on a requirement of the packaged electronic component 120 of the electronic component package body 10. For example, the pads 140 of the top surface 102 and the pins on the bottom surface 101 may be made of copper.

In this embodiment, the first pins 11 and the second pin 12 are disposed on a bottom plate of the electronic component package body 10, the pads 140 are disposed on the top surface 102, and a circuit layer capable of performing electrical connections is disposed on both sides of the electronic component package body 10 that are disposed facing away from each other, to provide a desirable basis for a double-sided interconnection of the electronic component 120 packaged inside the electronic component package body 10. This is conducive to implementing a shortest interconnection path and thin packaging of the package layer 107 in a limited space layout, and provides high practicability and reliability.

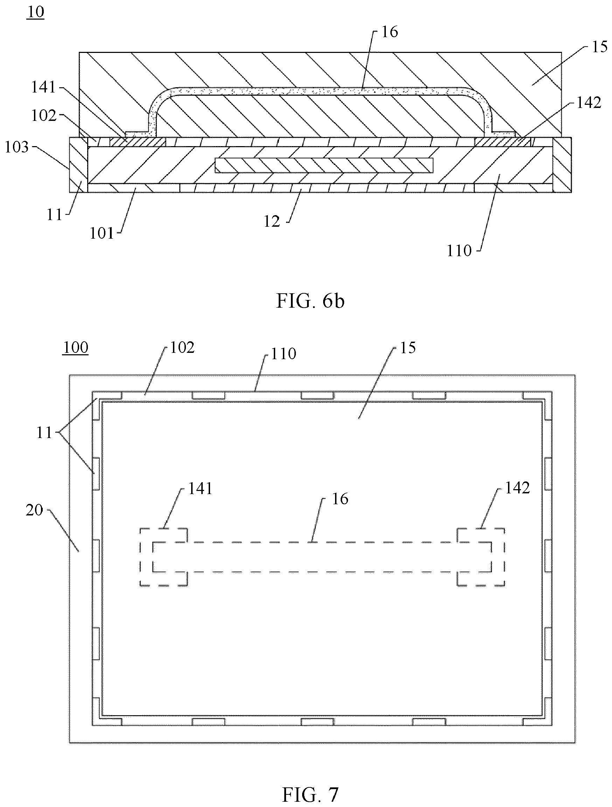

FIG. 6a is a schematic partial cross-sectional view of an electronic component package assembly 100 according to Embodiment 2 of this application. FIG. 6b is a schematic partial cross-sectional view of the electronic component package body 10 shown in FIG. 6a. The following mainly describes a difference between this embodiment and Embodiment 1, and most content of this embodiment that is the same as that of Embodiment 1 is not described again.

The difference between the electronic component package assembly 100 in Embodiment 2 and the electronic component package assembly 100 in Embodiment 1 lies in a structure of the electronic component package body 10. It can be understood that Embodiment 2 provided in this application describes the electronic component package body 10 in FIG. 6a. For example, the electronic component package body 10 includes a substrate 110, an electronic component 120 packaged inside the substrate 110, and a first pin 11 electrically connected to the electronic component 120. At least two adjacently disposed surfaces of the first pin 11 are exposed relative to the substrate 110. For example, the first pin 11 includes a bottom surface 111 of the first pin 11 and a side surface 112 of the first pin 11 connected to the bottom surface 111 of the first pin 11. The bottom surface 111 of the first pin 11 faces the circuit board 20, and both the bottom surface 111 of the first pin 11 and the side surface 112 of the first pin 11 are exposed relative to the substrate 110.

According to the claimed invention, a first pad 141 and a second pad 142 are disposed on the top surface 102. The first pad 141 is spaced from the second pad 142. It can be understood that the pads 140 include the first pad 141 and the second pad 142. The electronic component package body 10 further includes a bonding wire 16. The bonding wire 16 is electrically connected between the first pad 141 and the second pad 142, so that the first pad 141 is electrically connected to the second pad 142. For example, the bonding wire 16 is electrically connected to a first component 121 and a second component 122, and at least a partial structure of the bonding wire 16 is located outside the package layer 107.

Shapes, quantities, or the like of the first pad 141 and the second pad 142 are not limited in this application. A person skilled in the art can design the first pad 141 and the second pad 142 based on an actual requirement. The bonding wire 16 may be a metal wire or a metal strip. To be specific, the pads on the top surface 102 are bonded through wire bonding (wire bonding) and/or clip bonding (clip bonding). Quantities, locations, shapes, and the like of the first pad 141 and the second pad 142 on the top surface 102 are not limited in this application. A person skilled in the art can design the quantities, locations, shapes, and the like of the first pad 141 and the second pad 142 based on an actual requirement.

The first pad 141 and the second pad 142 on the top surface 102 are electrically connected through the bonding wire 16, to avoid remelting of the first pad 141 and the second pad 142 in a reflow soldering process when the first pad 141 and the second pad 142 are soldered through reflow soldering, thereby improving reliability of the electronic component package body 10.

Still refer to FIG. 6a and FIG. 6b. According to the claimed invention, the electronic component package body 10 further includes a package body 15. The package body 15 is located on a side that is of the substrate 110 and that is far away from the circuit board 20, the bonding wire 16 is packaged inside the package body 15, and the package body 15 is made of a magnetic material. For example, the magnetic material is a liquid magnetic material, and the bonding wire 16 is packaged through glue dispensing by using the liquid magnetic material, to form the package body 15 made of a magnetic material. A type of the magnetic material is not limited in this application, and a person skilled in the art can design the type of the magnetic material based on an actual requirement.

The pads 140 on the top surface 102 are electrically connected through the bonding wire 16, the package body 15 made of a magnetic material is disposed on a surface of the top surface 102, and the package body 15 and the bonding wire 16 jointly form a winding of a complete magnetic element (for example, a transformer or an inductor). This can prevent an excessively high current inside the electronic component package body 10, and is conducive to improving reliability of the electronic component package assembly 100. In addition, the package body 15 is seamlessly connected to the top surface 102, to facilitate heat dissipation of each electronic component 120 in the package layer 107, thereby improving heat dissipation performance of the electronic component package body 10.

An appearance of a microscopic insulating material inside the magnetic material is not conductive, and the package body 15 made of a magnetic material is not electrically connected to the bonding wire 16. For example, an internal part of the bonding wire 16 is made of a metal material, and an external part of the bonding wire 16 is wrapped by using an insulating material, to avoid mutual interference between the bonding wire 16 and the package body 15.

FIG. 7 is a top view of the electronic component package assembly 100 shown in FIG. 6a. The package body 15 covers a partial region of the top surface 102, and an edge of the top surface 102 is exposed relative to the package body 15. For example, the top surface 113 of the first pin 11 is exposed relative to the package body 15. It can be understood that an area of a projection of the package body 15 onto the circuit board 20 is less than an area of a projection of the substrate 110 onto the circuit board 20, and the projection of the package body 15 is located inside the projection of the substrate 110.

According to the claimed invention, a surface area of the package body 15 made of a magnetic material is less than a surface area of the substrate 110, the package body 15 covers a partial structure of the substrate 110, and the edge of the substrate 110 is exposed relative to the package body 15. Cutting the overall structure of the plurality of electronic component package bodies 10 into the single electronic component package body 10 can be implemented only by cutting the edge of the substrate 110, without cutting the package body 15. This avoids increasing cutting difficulty caused by cutting the package body 15, and reduces costs of the electronic component package body 10. It can be understood that the package body 15 is made of a magnetic material, and the cutting difficulty of the magnetic material is high. In this application, an area of the package body 15 is designed to be small, so that a structure of the edge of the substrate 110 is exposed relative to the package body 15, thereby reducing the cutting difficulty.

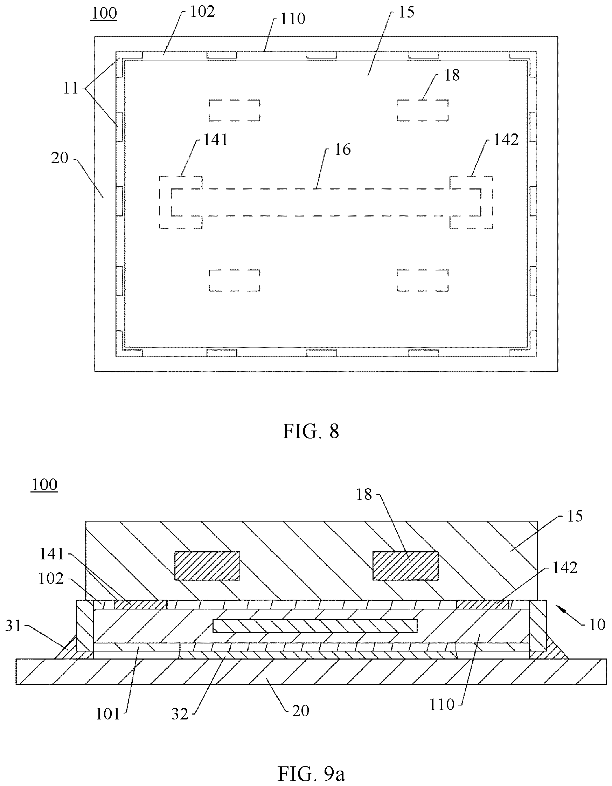

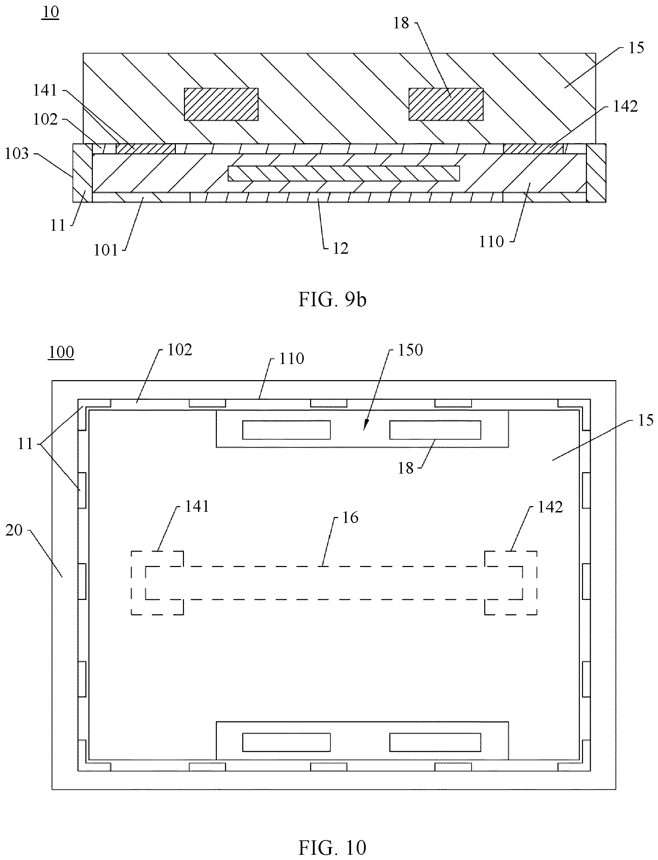

FIG. 8 is a top view of an electronic component package assembly 100 according to Embodiment 3 of this application. FIG. 9a is a schematic partial cross-sectional view of the electronic component package assembly 100 shown in FIG. 8. FIG. 9b is a schematic partial cross-sectional view of the electronic component package body 10 shown in FIG. 9a.

A difference between the electronic component package assembly 100 in Embodiment 3 and the electronic component package assembly 100 in the foregoing embodiments lies in a structure of the electronic component package body 10. It can be understood that Embodiment 3 provided in this application describes the electronic component package body 10 in FIG. 8 or FIG. 9a. The following mainly describes the difference between this embodiment and the foregoing embodiments, and most content of this embodiment that is the same as that of the foregoing embodiments is not described again. For example, the electronic component package body 10 includes a substrate 110, an electronic component 120 packaged inside the substrate 110, and a first pin 11 electrically connected to the electronic component 120. At least two adjacently disposed surfaces of the first pin 11 are exposed relative to the substrate 110. For example, the first pin 11 includes a bottom surface 111 of the first pin 11 and a side surface 112 of the first pin 11 connected to the bottom surface 111 of the first pin 11. The bottom surface 111 of the first pin 11 faces the circuit board 20, and both the bottom surface 111 of the first pin 11 and the side surface 112 of the first pin 11 are exposed relative to the substrate 110.

In this embodiment, the electronic component package assembly further includes an element 18. The element 18 is located on a side that is of the top surface 102 and that is far away from the bottom surface 101. For example, there are a plurality of elements 18, and the plurality of elements 18 are disposed at intervals. A type of the element 18 is not limited in this application. A person skilled in the art can design the type of the element 18 based on an actual requirement. For example, the element 18 may be an active component, for example, a chip, or may be a passive component, for example, a capacitor, an inductor, or a resistor.

The element 18 is packaged inside the package body 15. It can be understood that the element 18 is embedded inside the package body 15 and is not exposed relative to the package body 15, and the element 18 cannot be observed from an appearance of the electronic component package assembly. As shown in FIG. 8, a plurality of elements 18 are identified by dashed lines in the top view of the electronic component package assembly. A quantity, shapes, or locations of the elements 18 in FIG. 8 or FIG. 9a are merely used as an example, and are not limited in this application.

In this embodiment, a plurality of electronic components are disposed inside the substrate 110, and the plurality of elements 18 are disposed outside the substrate 110, to satisfy different requirements of the electronic component package body 10. For example, when a thickness of the electronic component is greater than or equal to that of the substrate 110, the electronic component may be placed outside the substrate 110. In addition, the plurality of elements 18 are packaged in the package body 15, and provide the packaged elements 18 with functions such as an electrical connection, protection, support, heat dissipation, and assembly.

As shown in FIG. 8, according to the claimed invention, the package body 15 covers a partial region of the top surface 102, and an edge of the top surface 102 is exposed relative to the package body 15. It can be understood that an area of a projection of the package body 15 onto the circuit board 20 is less than an area of a projection of the substrate 110 onto the circuit board 20, and the projection of the package body 15 is located inside the projection of the substrate 110.

The surface area of the package body 15 made of a magnetic material is less than a surface area of the substrate 110, the package body 15 covers a partial structure of the substrate 110, and the edge of the substrate 110 is exposed relative to the package body 15. Cutting the overall structure of the plurality of electronic component package bodies 10 into the single electronic component package body 10 can be implemented only by cutting the edge of the substrate 110, without cutting the package body 15. This avoids increasing cutting difficulty caused by cutting the package body 15, and reduces costs of the electronic component package body 10.

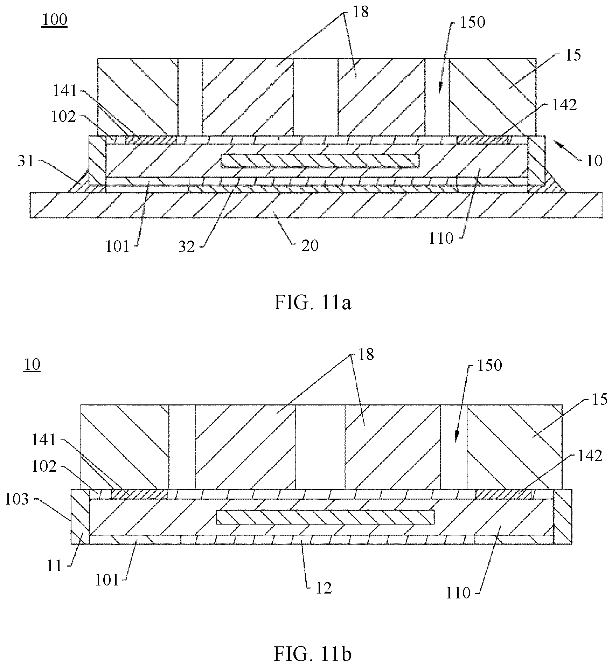

FIG. 10 is a top view of an electronic component package assembly 100 according to Embodiment 4 of this application. FIG. 11a is a schematic partial cross-sectional view of the electronic component package assembly 100 shown in FIG. 10. FIG. 11b is a schematic partial cross-sectional view of the electronic component package body 10 shown in FIG. 11a.

A difference between the electronic component package assembly 100 in Embodiment 4 and the electronic component package assembly 100 in the foregoing embodiments lies in a structure of the electronic component package body 10. It can be understood that Embodiment 4 provided in this application describes the electronic component package body 10 in FIG. 10 or FIG. 11a. The following mainly describes the difference between this embodiment and Embodiment 3, and most content of this embodiment that is the same as that of Embodiment 3 is not described again.

In this embodiment, a groove 150 is disposed in the package body 15, the element 18 is accommodated in the groove 150, and the element 18 is exposed relative to the package body 15. A quantity, shapes, or locations of the elements 18 in FIG. 10 or FIG. 11a are merely used as an example, and are not limited in this application. For example, there are a plurality of grooves 150. A plurality of elements 18 are disposed in one groove 150.

In this embodiment, the groove 150 for accommodating the element 18 is disposed in the package body 15, and the element 18 is exposed relative to the package body 15. The package body 15 may reserve a surface mount region of the element 18, to facilitate an electrical connection between the element 18 and another component. It can be understood that a person skilled in the art can design a location of the element 18 relative to the package body 15 based on an actual requirement. The element 18 may be exposed relative to the package body 15, or may be embedded inside the package body 15.

As shown in FIG. 10, according to the claimed invention, the package body 15 covers a partial region of the top surface 102, and an edge of the top surface 102 is exposed relative to the package body 15. For example, the top surface 113 of the first pin 11 is exposed relative to the package body 15. It can be understood that an area of a projection of the package body 15 onto the circuit board 20 is less than an area of a projection of the substrate 110 onto the circuit board 20, and the projection of the package body 15 is located inside the projection of the substrate 110.

The surface area of the package body 15 made of a magnetic material is less than a surface area of the substrate 110, the package body 15 covers a partial structure of the substrate 110, and the edge of the substrate 110 is exposed relative to the package body 15. Cutting the overall structure of the plurality of electronic component package bodies 10 into the single electronic component package body 10 can be implemented only by cutting the edge of the substrate 110, without cutting the package body 15. This avoids increasing cutting difficulty caused by cutting the package body 15, and reduces costs of the electronic component package body 10.

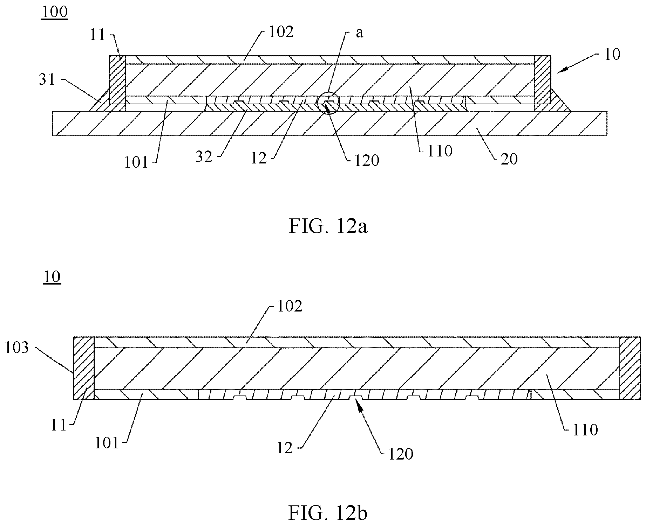

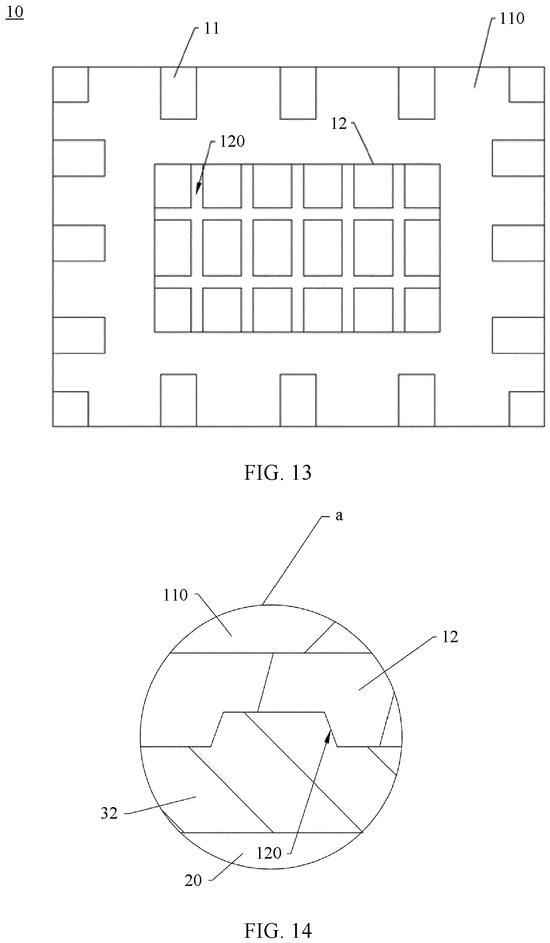

FIG. 12a is a schematic partial cross-sectional view of an electronic component package assembly 100 according to Embodiment 5 of this application. FIG. 12b is a schematic partial cross-sectional view of the electronic component package body 10 shown in FIG. 12a. FIG. 13 is a bottom view of the electronic component package body 10 shown in FIG. 12b.

A difference between the electronic component package assembly 100 in Embodiment 5 and the electronic component package assembly 100 in the foregoing embodiments lies in a structure of the electronic component package body 10. It can be understood that Embodiment 5 provided in this application describes the electronic component package body 10 in FIG. 12b or FIG. 13. The following mainly describes the difference between this embodiment and the foregoing embodiments, and most content of this embodiment that is the same as that of the foregoing embodiments is not described again. For example, the electronic component package body 10 includes a substrate 110, an electronic component 120 packaged inside the substrate 110, and a first pin 11 electrically connected to the electronic component 120. At least two adjacently disposed surfaces of the first pin 11 are exposed relative to the substrate 110. For example, the first pin 11 includes a bottom surface 111 of the first pin 11 and a side surface 112 of the first pin 11 connected to the bottom surface 111 of the first pin 11. The bottom surface 111 of the first pin 11 faces the circuit board 20, and both the bottom surface 111 of the first pin 11 and the side surface 112 of the first pin 11 are exposed relative to the substrate 110.

In this embodiment, the trench 120 is disposed on a side that is of the second pin 12 and that faces the circuit board 20. The trench 120 is recessed from a bottom surface of the first pin of the second pin 12 towards a side of the substrate 110, and a partial structure of the second soldering joint 32 is embedded in the trench 120. A plurality of trenches 120 may be obtained by using a cutting method. The cutting method may be but is not limited to etching or a laser technology. It can be understood that the second soldering joint 32 surrounds the bottom surface of the first pin of the second pin 12, and fills the trench 120. This increases a contact area between the second soldering joint 32 and the second pin 12. The trench 120 does not penetrate through the second pin 12. For example, there are a plurality of trenches 120. As shown in FIG. 13, for example, a recess depth of the trench 120 is merely used as an example, and a person skilled in the art can design the recess depth based on an actual requirement.

In this embodiment, the trench 120 is disposed on the side that is of the second pin 12 and that faces the circuit board 20, so that an exposed surface area of the second pin 12 is increased, and a soldering area of the second pin 12 is further increased. The solder may be used to fill the trench 120 during soldering of the electronic component package body 10, so that reliability of soldering the electronic component package body 10 and the circuit board 20 is further improved. A width, a depth, a quantity, or the like of the trench 120 is not limited in this application. A person skilled in the art can design dimensions of the trench 120 based on an actual requirement or a machine requirement.

FIG. 14 is an enlarged schematic diagram of a structure of a part a shown in FIG. 12a. In some embodiments, standard dimensions of the trench 120 gradually increase in a direction from an opening of the trench 120 toward a bottom of the trench 120. It can be understood that an area of the opening of the trench 120 is less than that of the bottom of the trench 120. For example, a cross-sectional shape of the trench 120 is an inverted trapezoid.

In this implementation, the standard dimensions of the trench 120 gradually increase in the direction from the opening of the trench 120 to the bottom of the trench 120. After the electronic component package body 10 and the circuit board 20 are soldered, the soldering joint that is in the electronic component package assembly 100 and that connects the electronic component package body 10 to the circuit board 20 forms an interlocking structure with the pins. In this way, strength of the soldering joint in a thickness direction of the electronic component package body 10 is further enhanced, thereby avoiding a failure of the soldering joint due to long-term vibration of the electronic component package assembly 100. This improves reliability of the electronic component package assembly 100.

The foregoing descriptions are merely specific implementations of this application, but are not intended to limit the protection scope of this application.

## Claims

1. An electronic component package body (10), comprising a substrate (110), an electronic component (120), and first pins (11), wherein the substrate comprises a bottom surface (101), a top surface (102), and a first side surface (103); the bottom surface (101) and the top surface (102) are disposed facing away from each other; the first side surface (103) is connected between the bottom surface (101) and the top surface (102); the electronic component (120) is packaged inside the substrate; the first pins (11) are embedded in the substrate (110), penetrate from the bottom surface (101) to the top surface (102), and are exposed on the first side surface (103); and a part of the first pin (11) that is exposed on the bottom surface (101) and a part of the first pin (11) that is exposed on the first side surface (103) are used for soldering with solder,
**characterized in that**
a first pad (141) and a second pad (142) are disposed on the top surface (102), the first pad (141) is spaced from the second pad (142), the electronic component package body (10) further comprises a bonding wire (16), and the bonding wire (16) is electrically connected between the first pad (141) and the second pad (142); and
the electronic component package body (10) further comprises a package body (15), the package body (15) is located on a side that is of the top surface (102) and that is far away from the bottom surface (101), the bonding wire (16) is packaged inside the package body (15), and the package body (15) is made of a magnetic material,
wherein the package body (15) covers a partial region of the top surface (102), and an edge of the top surface (102) is exposed relative to the package body (15).

2. The electronic component package body (10) according to claim 1, wherein there are a plurality of first pins (11), the plurality of first pins (11) are disposed at intervals, and the plurality of first pins (11) are all located on the first side surface (103).

3. The electronic component package body according to claim 1 to 2, wherein the electronic component package body (10) further comprises a second pin (12), the second pin (12) is spaced from the first pins (11), at least a partial structure of the second pin (12) is embedded in the substrate (110), the second pin (12) is away from the first side (103) surface relative to the first pins (11), and a bottom of the second pin (12) is used for soldering with solder.

4. The electronic component package body according to claim 3, wherein a trench (120) is disposed on the bottom of the second pin (12), the trench is recessed from a bottom surface of the second pin (12) towards a side of the substrate (110), and the trench (120) is used for soldering with solder.

5. An electronic component package assembly (100), comprising a circuit board, a first soldering joint (31), and the electronic component package body (10) according to any one of claims 1 to 4, wherein the electronic component package body (10) is mounted on the circuit board (20), the circuit board (20) is disposed opposite to the bottom surface (101), the first soldering joint (31) is connected between the first pin (11) and the circuit board (20), and the part of the first pin (11) that is exposed on the bottom surface (101) and the part of the first pin (11) that is exposed on the first side surface (103) are soldered at the first soldering joint (31).

6. The electronic component package assembly (110) according to claim 5, wherein the first soldering joint (31) comprises an integrally formed first segment (311) and second segment (312), the first segment (311) is connected between the circuit board (20) and the part of the first pin (11) that is exposed on the bottom surface (101), and the second segment (312) is connected between the circuit board (20) and the part of the first pin (11) that is exposed on the first side surface (103).

7. An electronic device, comprising a housing and the electronic component package assembly (100) according to claim 5 or 6, wherein the electronic component package assembly (100) is mounted on the housing.

## Patentansprüche

1. Baueinheitskörper (10) für elektronische Komponenten, der ein Substrat (110), eine elektronische Komponente (120) und erste Stifte (11) umfasst, wobei das Substrat eine untere Oberfläche (101), eine obere Oberfläche (102) und eine erste Seitenoberfläche (103) umfasst; wobei die untere Oberfläche (101) und die obere Oberfläche (102) einander abgewandt angeordnet sind; die erste Seitenoberfläche (103) zwischen der unteren Oberfläche (101) und der oberen Oberfläche (102) verbunden ist; die elektronische Komponente (120) innerhalb des Substrats untergebracht ist; die ersten Stifte (11) in das Substrat (110) eingebettet sind, von der unteren Oberfläche (101) zu der oberen Oberfläche (102) durchdringen und auf der ersten Seitenoberfläche (103) freiliegen; und ein Teil des ersten Stifts (11), der auf der unteren Oberfläche (101) freiliegt, und ein Teil des ersten Stifts (11), der auf der ersten Seitenoberfläche (103) freiliegt, zum Löten mit Lot verwendet werden,
**dadurch gekennzeichnet, dass**
eine erste Kontaktstelle (141) und eine zweite Kontaktstelle (142) auf der oberen Oberfläche (102) angeordnet sind, wobei die erste Kontaktstelle (141) von der zweiten Kontaktstelle (142) beabstandet ist, wobei der Baueinheitskörper (10) für elektronische Komponenten ferner einen Bonddraht (16) umfasst und der Bonddraht (16) zwischen der ersten Kontaktstelle (141) und der zweiten Kontaktstelle (142) elektrisch verbunden ist; und
wobei der Baueinheitskörper (10) für elektronische Komponenten ferner einen Baueinheitskörper (15) umfasst, wobei der Baueinheitskörper (15) sich auf einer Seite befindet, die zu der oberen Oberfläche (102) gehört und die von der unteren Oberfläche (101) weit entfernt ist, wobei der Bonddraht (16) innerhalb des Baueinheitskörpers (15) untergebracht ist und der Baueinheitskörper (15) aus magnetischem Material hergestellt ist,
wobei der Baueinheitskörper (15) einen Teilbereich der oberen Oberfläche (102) abdeckt und eine Kante der oberen Oberfläche (102) relativ zu dem Baueinheitskörper (15) freiliegt.

2. Baueinheitskörper (10) für elektronische Komponenten nach Anspruch 1, wobei es eine Vielzahl von ersten Stiften (11) gibt, wobei die Vielzahl von ersten Stiften (11) in Abständen angeordnet sind und die Vielzahl von ersten Stiften (11) sich alle auf der ersten Seitenoberfläche (103) befinden.

3. Baueinheitskörper für elektronische Komponenten nach Anspruch 1 bis 2, wobei der Baueinheitskörper (10) für elektronische Komponenten ferner einen zweiten Stift (12) umfasst, wobei der zweite Stift (12) von den ersten Stiften (11) beabstandet ist, wobei mindestens eine Teilstruktur des zweiten Stifts (12) in das Substrat (110) eingebettet ist, wobei der zweite Stift (12) von der ersten Oberfläche der Seite (103) relativ zu den ersten Stiften (11) entfernt ist, und eine Unterkante des zweiten Stifts (12) zum Löten mit Lot verwendet wird.

4. Baueinheitskörper für elektronische Komponenten nach Anspruch 3, wobei ein Schlitz (120) an der Unterkante des zweiten Stifts (12) angeordnet ist, wobei der Schlitz von einer unteren Oberfläche des zweiten Stifts (12) zu einer Seite des Substrats (110) hin vertieft ist und der Schlitz (120) zum Löten mit Lot verwendet wird.

5. Baueinheitsbaugruppe (100) für elektronische Komponenten, die eine Leiterplatte, eine erste Lötstelle (31) und den Baueinheitskörper (10) für elektronische Komponenten nach einem der Ansprüche 1 bis 4 umfasst, wobei der Baueinheitskörper (10) für elektronische Komponenten auf der Leiterplatte (20) montiert ist, die Leiterplatte (20) gegenüber der unteren Oberfläche (101) angeordnet ist, die erste Lötstelle (31) zwischen dem ersten Stift (11) und der Leiterplatte (20) verbunden ist, und der Teil des ersten Stifts (11), der auf der unteren Oberfläche (101) freiliegt, und der Teil des ersten Stifts (11), der auf der ersten Seitenoberfläche (103) freiliegt, an der ersten Lötstelle (31) verlötet sind.

6. Baueinheitsbaugruppe für elektronische Komponenten (110) nach Anspruch 5, wobei die erste Lötstelle (31) ein einstückig ausgebildetes erstes Segment (311) und zweites Segment (312) umfasst, wobei das erste Segment (311) zwischen der Leiterplatte (20) und dem Teil des ersten Stifts (11), der auf der unteren Oberfläche (101) freiliegt, verbunden ist, und das zweite Segment (312) zwischen der Leiterplatte (20) und dem Teil des ersten Stifts (11), der auf der ersten Seitenoberfläche (103) freiliegt, verbunden ist.

7. Elektronische Vorrichtung, die ein Gehäuse und die Baueinheitsbaugruppe (100) für elektronische Komponenten nach Anspruch 5 oder 6 umfasst, wobei die Baueinheitsbaugruppe (100) für elektronische Komponenten an der Baueinheit montiert ist.

## Revendications

1. Corps de boîtier de composant électronique (10), comprenant un substrat (110), un composant électronique (120) et des premières broches (11), dans lequel le substrat comprend une surface inférieure (101), une surface supérieure (102) et une première surface latérale (103) ; la surface inférieure (101) et la surface supérieure (102) sont disposées à l'opposé l'une de l'autre ; la première surface latérale (103) est reliée entre la surface inférieure (101) et la surface supérieure (102) ; le composant électronique (120) est conditionné à l'intérieur du substrat ; les premières broches (11) sont intégrées dans le substrat (110), pénètrent de la surface inférieure (101) à la surface supérieure (102), et sont exposées sur la première surface latérale (103) ; et une partie de la première broche (11) qui est exposée sur la surface inférieure (101) et une partie de la première broche (11) qui est exposée sur la première surface latérale (103) sont utilisés pour être soudées par soudure,
**caractérisé en ce que**
un premier plot (141) et un second plot (142) sont disposés sur la surface supérieure (102), le premier plot (141) est espacé du second plot (142), le corps de boîtier de composant électronique (10) comprend en outre un fil de connexion (16), et le fil de connexion (16) est connecté électriquement entre le premier plot (141) et le second plot (142) ; et
le corps de boîtier de composant électronique (10) comprend en outre un corps de boîtier (15), le corps de boîtier (15) est situé sur le côté qui fait partie de la surface supérieure (102) et qui est éloigné de la surface inférieure (101), le fil de connexion (16) est conditionné à l'intérieur du corps de boîtier (15), et le corps de boîtier (15) est fait d'un matériau magnétique,
dans lequel le corps de boîtier (15) couvre une région partielle de la surface supérieure (102), et un bord de la surface supérieure (102) est exposé par rapport au corps de boîtier (15).

2. Corps de boîtier de composant électronique (10) selon la revendication 1, dans lequel se trouve une pluralité de premières broches (11), la pluralité de premières broches (11) sont disposées à intervalles, et la pluralité de premières broches (11) sont toutes situées sur la première surface latérale (103).

3. Corps de boîtier de composant électronique selon la revendication 1 à 2, dans lequel le corps de boîtier de composant électronique (10) comprend en outre une seconde broche (12), la seconde broche (12) est espacée des premières broches (11), au moins une structure partielle de la seconde broche (12) est intégrée dans le substrat (110), la seconde broche (12) est à distance de la première surface latérale (103) par rapport aux premières broches (11), et un fond de la seconde broche (12) est utilisé pour être soudé par soudure.

4. Corps de boîtier de composant électronique selon la revendication 3, dans lequel une tranchée (120) est disposée sur le fond de la seconde broche (12), la tranchée est en retrait d'une surface inférieure de la seconde broche (12) vers un côté du substrat (110), et la tranchée (120) est utilisée pour être soudée par soudure.

5. Ensemble boîtier de composant électronique (100), comprenant une carte de circuit imprimé, un premier joint de soudure (31) et le corps de boîtier de composant électronique (10) selon l'une quelconque des revendications 1 à 4, dans lequel le corps de boîtier de composant électronique (10) est monté sur la carte de circuit imprimé (20), la carte de circuit imprimé (20) est disposée à l'opposé de la surface inférieure (101), le premier joint de soudure (31) est relié entre la première broche (11) et la carte de circuit imprimé (20), et la partie de la première broche (11) qui est exposée sur la surface inférieure (101) et la partie de la première broche (11) qui est exposée sur la première surface latérale (103) sont soudées au niveau du premier joint de soudure (31).

6. Ensemble boîtier de composant électronique (110) selon la revendication 5, dans lequel le premier joint de soudure (31) comprend un premier segment formé d'un seul tenant (311) et un second segment (312), le premier segment (311) est relié entre la carte de circuit imprimé (20) et la partie de la première broche (11) qui est exposée sur la surface inférieure (101), et le second segment (312) est relié entre la carte de circuit imprimé (20) et la partie de la première broche (11) qui est exposée sur la première surface latérale (103).

7. Dispositif électronique, comprenant un logement et l'ensemble de boîtier de composant électronique (100) selon l'une quelconque des revendications 5 à 6, dans lequel l'ensemble de boîtier de composant électronique (100) est monté sur le logement.
